# EUROPEAN PATENT SPECIFICATION

(11) **EP 3 336 912 B1**
(45) Date of publication and mention of the grant of the patent: **15.04.2020**
(21) Application number: 17204674.0
(22) Date of filing: 30.11.2017
(51) Int. Cl.: H01L 41/187, H01L 41/08, B41J 2/14

(54) **PIEZOELECTRIC FILM ELEMENT**
BAUELEMENT MIT PIEZOELEKTRISCHEM FILM
COMPOSANT À COUCHE PIÉZOÉLECTRIQUE

(30) Priority: 19.12.2016 JP 2016245876
(43) Date of publication of application: 20.06.2018
(73) Proprietor: Seiko Epson Corporation, Tokyo 160-8801 (JP)
(72) Inventor: KITADA, Kazuya, Suwa-shi, Nagano 392-8502 (JP); SUMI, Koji, Suwa-shi, Nagano 392-8502 (JP); ISSHIKI, Tetsuya, Suwa-shi, Nagano 392-8502 (JP); SAKAI, Tomohiro, Suwa-shi, Nagano 392-8502 (JP); TAKAHASHI, Toshiaki, Suwa-shi, Nagano 392-8502 (JP)
(74) Representative: Miller Sturt Kenyon

(56) References cited:
- EP-A1- 3 098 868
- WANG L ET AL: "Structures and electrical properties of Mn- and Co-doped lead-free ferroelectric K0.5Na0.5NbO3 films prepared by a chemical solution deposition method", THIN SOLID FILMS, vol. 537, 25 April 2013 (2013-04-25), pages 65-69, XP055471948, ISSN: 0040-6090, DOI: 10.1016/j.tsf.2013.04.045

## Description

### BACKGROUND

### 1. Technical Field

The present invention relates to a piezoelectric element and a piezoelectric element device.

### 2. Related Art

A piezoelectric element typically includes a piezoelectric layer that exhibits electromechanical conversion characteristics, and two electrodes sandwiching the piezoelectric layer. In recent years, the development of devices (piezoelectric element devices) equipped with such piezoelectric elements as driving sources has been actively investigated. Examples of the piezoelectric element devices include liquid ejecting heads, such as ink jet recording heads; MEMS components, such as piezoelectric MEMS elements; ultrasonic measuring devices, such as ultrasonic sensors; and piezoelectric actuator devices.

Recently, for example, environmentally friendly lead-free materials have drawn attention as piezoelectric materials for piezoelectric elements employed in liquid ejecting heads. Among such materials, potassium sodium niobate ((K,Na)NbO₃, hereinafter referred to as "KNN") having a high voltage characteristic has been proposed (see, for example, JP-A-2014-60267 and JP-A-2014-65317). In JP-A-2014-60267, a piezoelectric element is formed by stacking a titanium (Ti) lower bonding layer, a lower electrode, a KNN piezoelectric layer, and an upper electrode, for example, on a substrate. In JP-A-2014-65317, a piezoelectric element is formed by stacking an elastic layer, a bonding layer made of Ti or the like, a first electrode, a KNN piezoelectric layer, and a second electrode, for example, on a substrate.

A serious problem of KNN is its poor insulating properties. Thus, there is proposed a method of improving insulating properties of a piezoelectric element by adding an additive, such as manganese (Mn), to KNN, thereby reducing leakage current (see Matsuda et al., Japanese Journal of Applied Physics, 51, 2012, 09LA03).

It is known, however, that crystallinity and crystal orientation of KNN as well as insulating properties vary considerably depending on a state of the crystal structure and/or the state of an additive in the crystal, thereby affecting the piezoelectric characteristics. EP 3 098 868 A1 discloses a piezoelectric element according to the preamble of the independent claim, wherein a 0.5% Mn-doped KNN layer with 6% A-site excess shows a Mn²⁺/(Mn³⁺+Mn⁴⁺) ratio of 2.1 (Example 3). Particularly, the optimal state of an additive in the crystal remains unknown. Such issues are not limited to piezoelectric elements that are employed in liquid ejecting heads, but are also shared with piezoelectric elements employed in other piezoelectric element devices.

### SUMMARY

An advantage of the invention is to determine the optimal state of the valence of manganese contained as an additive in the crystal and to enhance the crystal orientation of a piezoelectric layer, thereby providing a piezoelectric element and a piezoelectric element device that exhibit excellent insulating properties.

A piezoelectric element according to the present invention includes: a first electrode formed on a substrate; a piezoelectric layer formed on the first electrode and composed of a complex oxide having a perovskite structure containing potassium (K), sodium (Na), niobium (Nb), and manganese (Mn); and a second electrode formed on the piezoelectric layer, in which the manganese includes divalent manganese (Mn²⁺), trivalent manganese (Mn³⁺), and tetravalent manganese (Mn⁴⁺); a molar ratio of the divalent manganese to a sum of the trivalent manganese and the tetravalent manganese (Mn²⁺/(Mn³⁺ + Mn⁴⁺)) is 1 or more and 10 or less; and a molar ratio of the potassium to the sodium (K/Na) at the surface of the piezoelectric layer, measured by X-ray photoelectron spectroscopy (XPS), is 0.8 to 1.1. Thus, it becomes possible to enhance the crystal orientation of a layer due to a reduced leakage current and high insulating properties. Further, it becomes possible to enhance piezoelectric properties since an engineered domain structure is readily obtained by enhancing the crystal orientation of a piezoelectric layer.

In the piezoelectric element, according to the present invention, the complex oxide having a perovskite structure represented by a general formula of ABO₃ includes an A-site element added in excess relative to a B-site element, and an amount of the excess is 4% or more and 6% or less. This makes it possible to obtain a piezoelectric element having good leakage characteristics.

Further, in the piezoelectric element, the complex oxide having a perovskite structure is preferably represented by formula (1):

(Kₓ,Na₍₁₋ₓ₎)(Nb_{(1-y)},Mn_{y})O₃ (1)

where x satisfies 0.1 ≤x≤ 0.9, preferably 0.3 ≤x≤ 0.7, and more preferably 0.4≤x≤0.6; and y satisfies 0.003≤y≤0.02 and preferably 0.005≤y≤0.01. This makes it possible to obtain a piezoelectric element having excellent piezoelectric characteristics.

According to another aspect of the invention, a piezoelectric element device including the piezoelectric element is provided. According to this aspect, it becomes possible to provide a device with excellent functionality.

### BRIEF DESCRIPTION OF THE DRAWINGS

The invention will be described with reference to the accompanying drawings, wherein like numbers reference like elements.
Fig. 1 is a view illustrating a schematic configuration of an ink jet recording apparatus.
Fig. 2 is an exploded perspective view illustrating a schematic configuration of an ink jet recording head.
Fig. 3 is a plan view illustrating the schematic configuration of the ink jet recording head.
Fig. 4 is a sectional view illustrating the schematic configuration of the ink jet recording head.
Fig. 5 is an enlarged sectional view illustrating the schematic configuration of the ink jet recording head.
Fig. 6 is a sectional view illustrating an example of manufacturing the ink jet recording head.
Fig. 7 is a sectional view illustrating the example of manufacturing the ink jet recording head.
Fig. 8 is a sectional view illustrating the example of manufacturing the ink jet recording head.
Fig. 9 is a sectional view illustrating the example of manufacturing the ink jet recording head.
Fig. 10 is a sectional view illustrating the example of manufacturing the ink jet recording head.
Fig. 11 is a sectional view illustrating the example of manufacturing the ink jet recording head.
Fig. 12 is a sectional view illustrating the example of manufacturing the ink jet recording head.
Fig. 13 is a graph indicating an XRD measurement result of Sample 1.

### DESCRIPTION OF EXEMPLARY EMBODIMENTS

Hereinafter, embodiments of the invention will be described with reference to the drawings. The description below illustrates only an aspect of the invention, and thus modifications are possible without departing from the scope of the present invention, solely defined by the appended claims. In the drawings, like numerals denote like components and description thereof is omitted as appropriate. X, Y, and Z represent three mutually orthogonal spatial axes. In this specification, the description will be given with directions along these axes as a first direction (X direction), a second direction (Y direction), and a third direction (Z direction), with a direction pointed by an arrow in the drawings as a positive (+) direction, and a direction opposite to the direction pointed by the arrow as a negative (-) direction. The X direction and Y direction represent directions parallel to a plane of a sheet, a layer, and a film, and the Z direction represents a thickness direction or the stacking direction of a sheet, a layer, and a film.

The components illustrated in the drawings, i.e., the shape and/or size of each part, layer thickness, relative positional relationship, and repeating units, for example, are sometimes exaggerated in illustrations of the invention. Further, the term "on" in the specification is not limited to "directly on" with respect to the positional relationship of the components. For example, expressions, such as "a first electrode on a substrate" and "a piezoelectric layer on the first electrode" do not exclude a case in which another component is placed between the substrate and the first electrode or between the first electrode and the piezoelectric layer.

### Embodiment 1

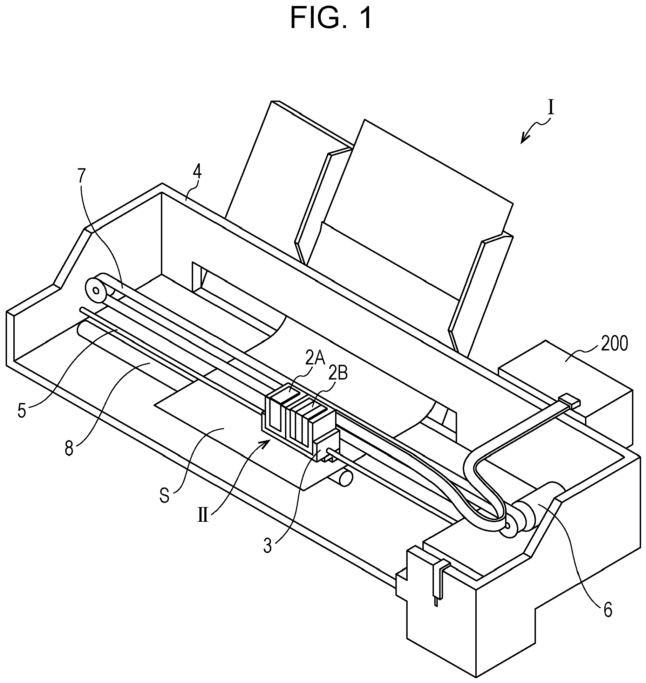

First, with reference to Fig. 1, an ink jet recording apparatus will be described as an example of a liquid ejecting apparatus.

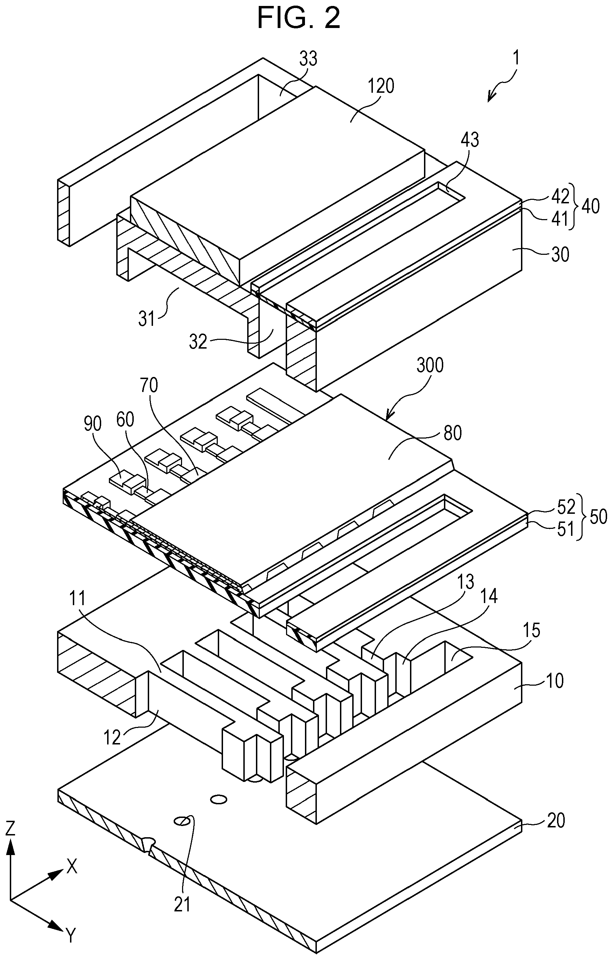

Fig. 1 is a view illustrating a schematic configuration of an ink jet recording apparatus. As illustrated, in an ink jet recording apparatus (recording apparatus I), an ink jet recording head unit (head unit II) is detachably provided in cartridges 2A and 2B. The cartridges 2A and 2B constitute an ink supply mechanism. The head unit II includes a plurality of ink jet recording heads (recording head 1; see Fig. 2, for example) described hereinafter, and is mounted on a carriage 3. The carriage 3 is provided on a carriage shaft 5, which is fixed to an apparatus body 4, so as to be movable in the axial direction. The head unit II and the carriage 3 are each configured to discharge a black ink composition and a color ink composition, for example.

The driving force of a driving motor 6 is transmitted to the carriage 3 via a plurality of gears (not shown) and a timing belt 7 such that the carriage 3 on which the head unit II is mounted is moved along the carriage shaft 5. Meanwhile, a transport roller 8 is provided in the apparatus body 4 as a transport mechanism, and a recording sheet S, which is a recording medium such as paper, is transported by the transport roller 8. A transport mechanism for transporting the recording sheet S is not limited to a transport roller and may be a belt or a drum, for example.

The recording head 1 employs as a piezoelectric actuator device a piezoelectric element 300 (see Fig. 2, for example) according to an embodiment of the invention. By employing the piezoelectric element 300, a reduction in various characteristics such as durability and ink ejection characteristic of the recording apparatus I can be avoided.

Next, with reference to Figs. 2 to 4, an ink jet recording head will be described as an example of a liquid ejecting head that is mounted on a liquid ejecting apparatus.

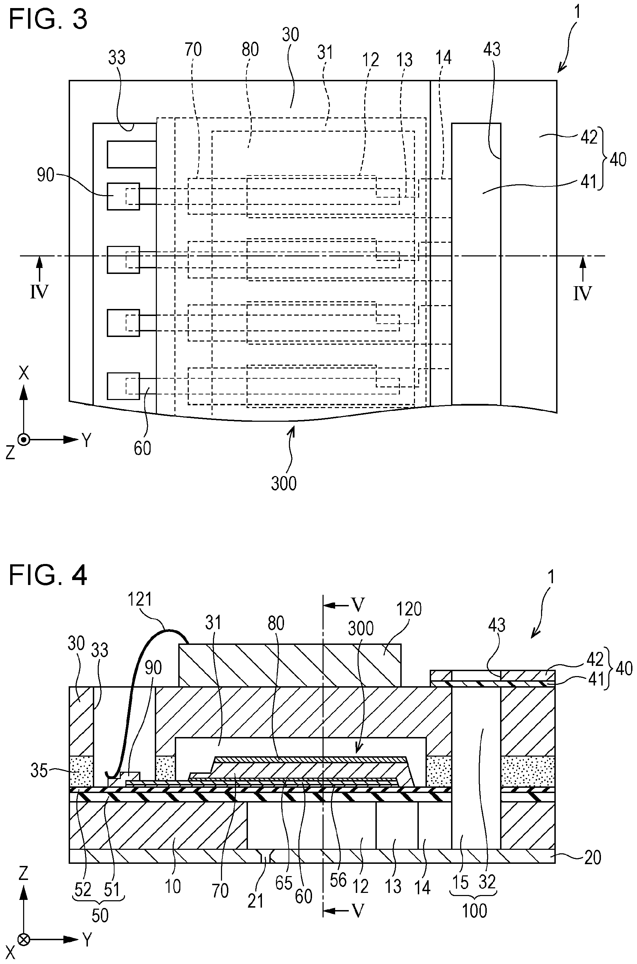

Fig. 2 is an exploded perspective view of an ink jet recording head. Fig. 3 is a plan view of a channel-forming substrate on the side of a piezoelectric element (a plan view of the substrate viewed from the side of the piezoelectric element). Fig. 4 is a sectional view taken along line IV-IV in Fig. 3.

As illustrated, the channel-forming substrate (hereinafter, referred to as "substrate 10") is composed of a silicon single crystal substrate (Si substrate), for example, and pressure chambers 12 are formed therein. The pressure chambers 12 partitioned by a plurality of partition walls 11 are provided in an aligning direction (X direction) of a plurality of nozzle openings 21 that discharge an ink of the same color. A material for the substrate 10 is not limited to silicon (Si) and may be SOI or glass, for example.

Ink supply paths 13 and connecting paths 14 are formed at one end of the pressure chambers 12 in the substrate 10 in the Y direction. The ink supply paths 13 are formed by narrowing one end (+Y direction end) of the pressure chambers 12 to reduce the area of openings. The connecting paths 14 have substantially the same widths as the pressure chambers 12 in the X direction. Outside the connecting paths 14 (+Y direction side), a connecting portion 15 is formed. The connecting portion 15 constitutes a part of a manifold 100. The manifold 100 constitutes a common ink chamber for pressure chambers 12. As described above, a liquid channel including the pressure chambers 12, the ink supply paths 13, the connecting paths 14, and the connecting portion 15 is formed in the substrate 10.

On one surface of the substrate 10 (the surface on the -Z direction side), a nozzle plate 20 made of SUS, for example, is joined. In the nozzle plate 20, nozzle openings 21 aligning in the X direction are provided. The nozzle openings 21 are connected to respective pressure chambers 12. The nozzle plate 20 and the substrate 10 can be joined to each other by using an adhesive or a heat-sealing film, for example.

On the other surface (the surface on the +Z direction side) of the substrate 10, a diaphragm 50 is formed. The diaphragm 50 includes an elastic film 51 formed on the substrate 10 and an insulator film 52 formed on the elastic film 51. The elastic film 51 is composed of silicon dioxide (SiO₂), for example, and the insulator film 52 is composed of zirconium oxide (ZrO₂), for example. The elastic film 51 is not necessarily a component separate from the substrate 10. The elastic film may be a thinned part of the substrate 10.

On the insulator film 52, the piezoelectric element 300 including a first electrode 60, a seed layer 65, a piezoelectric layer 70, and a second electrode 80 is formed via a bonding layer 56. The bonding layer 56 is composed of titanium oxide (TiOₓ), titanium (Ti), or silicon nitride (SiN), for example, and serves to enhance adhesion between the piezoelectric layer 70 and the diaphragm 50. The bonding layer 56 can be omitted. In the embodiment, the seed layer 65 (orientation control layer) is provided, for example, on the bonding layer 56 between the first electrode 60 and the piezoelectric layer 70. The seed layer 65 serves to control the orientation of the piezoelectric layer 70. The seed layer 65 can be omitted.

In the embodiment, the displacement of the piezoelectric layer 70 having electromechanical conversion characteristics causes the displacement of the diaphragm 50 and the first electrode 60. In other words, in the embodiment, the diaphragm 50 and the first electrode 60 substantially function as a diaphragm. By omitting the elastic film 51 and the insulator film 52, the first electrode 60 alone may be set to function as a diaphragm. When the first electrode 60 is provided directly on the substrate 10, the first electrode 60 is preferably protected with a protective insulating film, for example, to avoid contact with an ink.

A first electrode 60 is provided in every pressure chamber 12. In other words, the first electrode 60 is formed as an independent individual electrode in every pressure chamber 12. The first electrode 60 is formed to have a narrower width than the pressure chamber 12 in the X direction. Moreover, the first electrode 60 is formed to have a wider width than the pressure chamber 12 in the Y direction. This means that both ends of the first electrode 60 are formed outside a region facing the pressure chamber 12. In the Y direction, one end of the first electrode 60 (end opposite to the connecting path 14) is connected to a lead electrode 90.

The piezoelectric layer 70 is provided between the first electrode 60 and the second electrode 80. The piezoelectric layer 70 is formed to have a wider width than the first electrode 60 in the X direction. The piezoelectric layer 70 is formed to have a width wider than the length of the pressure chamber 12 in the Y direction. In the Y direction, the end of the piezoelectric layer 70 on the side of the ink supply path 13 (+Y direction end) is formed outside the end of the first electrode 60. This means that the end of the first electrode 60 (+Y direction end) is covered with the piezoelectric layer 70. Meanwhile, the end (-Y direction end) of the piezoelectric layer 70 is positioned inside (toward +Y direction side) as compared to the end (-Y direction end) of the first electrode 60. This means that the end of the first electrode 60 is not covered by the piezoelectric layer 70.

The second electrode 80 is provided continuously on the piezoelectric layers 70, the first electrodes 60, and the diaphragm 50 in the X direction. In other words, the second electrode 80 is formed as a common electrode shared with a plurality of the piezoelectric layers 70. In the embodiment, there is illustrated a liquid ejecting head in which the first electrodes 60 are individual electrodes independently provided to respective pressure chambers 12, and the second electrode 80 constitutes a common electrode provided continuously in the aligning direction of pressure chambers 12. Conversely, the first electrode 60 may constitute a common electrode provided continuously in the aligning direction of the pressure chambers 12, and the second electrode 80 may be individual electrodes independently provided to respective pressure chambers 12.

A protective substrate 30 is joined, by an adhesive 35, to the substrate 10 on which the piezoelectric element 300 is formed. The protective substrate 30 has a manifold portion 32. The manifold portion 32 constitutes at least part of the manifold 100. The manifold portion 32 of the embodiment penetrates the protective substrate 30 in the thickness direction (-Z direction) and is formed in the width direction (X direction) of the pressure chambers 12. As described above, the manifold portion 32 is connected to the connecting portion 15 of the substrate 10. The manifold 100 constituting a common ink chamber for pressure chambers 12 is formed with the above configuration.

In the protective substrate 30, a piezoelectric element holding portion 31 is formed in a region where the piezoelectric element 300 is present. The piezoelectric element holding portion 31 has a space that does not impede the movement of the piezoelectric element 300. The space may be sealed or non-sealed. The protective substrate 30 has a through hole 33 that penetrates the protective substrate 30 in the thickness direction. Inside the through hole 33, an end of the lead electrode 90 is exposed.

Examples of materials for the protective substrate 30 include glass, ceramics, metals, and resins. The protective substrate 30, however, is preferably formed from a material having a substantially identical thermal expansion rate to the substrate 10. In the embodiment, the protective substrate 30 is formed from a silicon single crystal substrate (Si substrate), which is an identical material to the substrate 10.

On the protective substrate 30, a driving circuit 120 that functions as a signal processing section is fixed. The driving circuit 120 can be a circuit board or a semiconductor integrated circuit (IC), for example. The driving circuit 120 and the lead electrode 90 are electrically coupled through connecting wiring 121 composed of a conductive wire, such as a bonding wire, inserted into the through hole 33. The driving circuit 120 can be electrically coupled with a printer controller 200 (see Fig. 1). Such a driving circuit 120 functions as a controller of an actuator device (piezoelectric element 300).

A compliant substrate 40 including a sealing film 41 and a fixing plate 42 is joined to the protective substrate 30. The sealing film 41 can be composed of a low-rigidity material, and the fixing plate 42 can be formed from a hard material, such as a metal. A portion of the fixing plate 42 that faces the manifold 100 is completely removed in the thickness direction (-Z direction) to provide an opening 43. One side of the manifold 100 (the +Z direction side) is sealed solely by the sealing film 41 having flexibility.

The ink jet recording head described above discharges ink droplets through the following operations. First, an ink is fed to the recording head from an ink inlet that is connected to an external ink supply mechanism (not shown) to fill the inside of the recording head, i.e., from the manifold 100 to the nozzle openings 21, with the ink. Then, in accordance with a recording signal from the driving circuit 120, a voltage is applied between the second electrode 80 and each of the first electrodes 60 corresponding to respective pressure chambers 12, thereby bending and distorting the piezoelectric element 300. This increases the pressure inside pressure chambers 12 and causes ink droplets to be discharged from the nozzle openings 21.

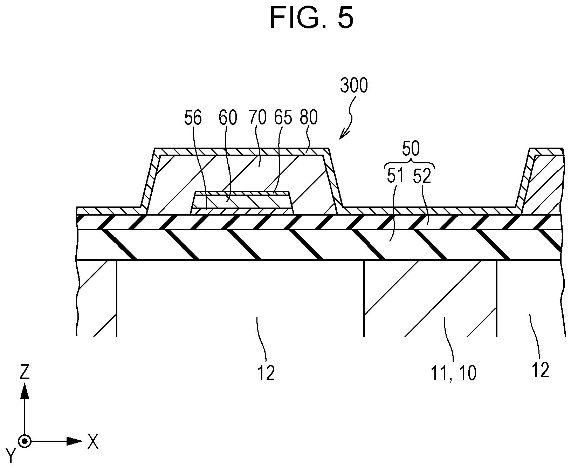

Following, the piezoelectric element 300 will be described in detail with reference to Fig. 5. Fig. 5 is an enlarged sectional view of the vicinity of the piezoelectric element taken along line V-V in Fig. 4.

As illustrated in Fig. 5, the piezoelectric element 300 includes the bonding layer 56, the first electrode 60, the seed layer 65, the piezoelectric layer 70, and the second electrode 80. The thickness of the insulator film 52 is 20 nm. The thickness of the bonding layer 56 is 10 nm. The thickness of the first electrode 60 is 0.1 µm. The thickness of the seed layer 65 is 80 nm or less and preferably 10 nm or more and 50 nm or less. The piezoelectric layer 70 is a thin-film piezoelectric material having a thickness of 3.0 µm or less, preferably 0.3 µm or more and 2.0 µm or less, and more preferably 0.5 µm or more and 1.5 µm or less. The thickness of the second electrode is 0.1 µm. All of the thicknesses mentioned above are examples, and can be changed without departing from the present invention.

Materials for the first electrode 60 and the second electrode 80 may be any electrode material that can retain the conductivity without undergoing oxidation during the formation of the piezoelectric element 300. Examples of such materials include metals, such as platinum (Pt), iridium (Ir), gold (Au), aluminum (Al), copper (Cu), Ti, silver (Ag), and stainless steel; iridium oxide (IrOₓ); tin oxide-based conductive materials, such as indium tin oxide (ITO) and fluorine-doped tin oxide (FTO); zinc oxide-based conductive materials; oxide conductive materials, such as strontium ruthenate (SrRuO₃), lanthanum nickel oxide (LaNiO₃), and element-doped strontium titanate; and conducting polymers. Among these, noble metals, such as Pt and Ir, are preferred. As the electrode material, any of the above materials may be used alone, or a layered structure of a plurality of the materials may be used. Materials for the first electrode 60 and the second electrode 80 may be the same or different.

In the embodiment, alkali metals, such as potassium (K) and sodium (Na), contained in a piezoelectric material, sometimes diffuse into the first electrode 60 in the process of forming the piezoelectric layer 70. As mentioned hereinafter, however, the insulator film 52 provided between the first electrode 60 and the substrate 10 functions as a barrier against the alkali metals. This can reduce the alkali metals from reaching the substrate 10.

In the embodiment, the seed layer 65 is formed on the first electrode 60 during the formation of the piezoelectric layer 70. As described hereinafter, the seed layer 65 functions as an orientation control layer that enables the piezoelectric layer 70 to have a preferred orientation along a predetermined plane. A material for the seed layer 65 may be, for example, a piezoelectric material similar to that for the piezoelectric layer 70 described hereinafter, but can be appropriately selected as needed without limitation.

The piezoelectric layer 70 is formed from a piezoelectric material composed of a complex oxide (ABO₃ perovskite complex oxide) having a perovskite structure represented by a general formula of ABO₃. In the embodiment, an ABO₃ perovskite complex oxide containing K, Na, niobium (Nb), and manganese (Mn) is used as a piezoelectric material. Examples of such complex oxides include a Mn-containing KNN-based complex oxide represented by formula (2):

(Kₓ,Na₍₁₋ₓ₎)(Nb_{(1-y)},Mn_{y})O₃ (2)

In formula (2), x satisfies 0.1 ≤ x ≤ 0.9, preferably 0.3 ≤ x ≤ 0.7, and more preferably 0.4 ≤ x ≤ 0.6; and y satisfies 0.003 ≤ y ≤ 0.02 and preferably 0.005 ≤ y ≤ 0.01.

In the ABO₃ perovskite complex oxide, the A site is in 12-fold coordination with oxygen and the B site is in 6-fold coordination with oxygen, forming an octahedron. K and Na occupy the A site, and Nb and Mn occupy the B site in the ABO₃ perovskite complex oxide containing K, Na, Nb, and Mn.

The complex oxide represented by formula (2) is a Mn-containing KNN-based complex oxide. The complex oxide is a lead (Pb)-free piezoelectric material and thus exhibits excellent biocompatibility and has a low environmental load. In addition, the complex oxide exhibits excellent piezoelectric characteristics among lead-free piezoelectric materials and thus is advantageous to enhance various characteristics. Further, the complex oxide has a Curie temperature relatively higher than other lead-free piezoelectric materials and is less susceptible to depolarization due to an increase in temperature. Consequently, use of the complex oxide at a high temperature is possible. Examples of other lead-free piezoelectric materials include bismuth ferrite (BiFeO₃, referred to as "BFO"), barium titanate (BaTiO₃, referred to as "BT"), potassium sodium lithium niobate ((K,Na,Li)NbO₃), potassium sodium lithium niobate tantalate ((K,Na,Li)(NbTa)O₃), bismuth potassium titanate ((Bi_{1/2}K_{1/2})TiO₃, referred to as "BKT"), bismuth sodium titanate ((Bi_{1/2}Na_{1/2})TiO₃, referred to as "BNT"), bismuth manganate (BiMnO₃, referred to as "BM"), a complex oxide containing bismuth (Bi), K, Ti, and iron (Fe)((Bi,K)(Ti,Fe)O₃), a complex oxide containing Bi, Fe, barium (Ba), and Ti ((Bi,Ba)(Fe,Ti)O₃), and a complex oxide further containing a metal, such as Mn, cobalt (Co), or chromium (Cr) ((Bi,Ba)(Fe,Ti,M)O₃); M is Mn, Co, or Cr).

As an additive, Mn is contained in a form including divalent Mn (Mn²⁺), trivalent Mn (Mn³⁺), and tetravalent Mn (Mn⁴⁺). The molar ratio (Mn²⁺/(Mn³⁺ + Mn⁴⁺)) of divalent Mn to the sum of trivalent Mn and tetravalent Mn is preferably 1 or more and 10 or less (1 ≤ (Mn²⁺/(Mn³⁺ + Mn⁴⁺) ≤ 10), particularly preferably 1.92 or more and 7.19 or less. When the molar ratio of divalent Mn is set within the above range, a piezoelectric element 300 having excellent insulating properties can be obtained with enhanced crystal orientation of the piezoelectric layer 70 and reduced leakage current. Meanwhile, when the molar ratio of divalent Mn is outside the above range, the piezoelectric element 300 having excellent insulating properties cannot be obtained with lowered crystal orientation.

The ratio of divalent Mn is believed to vary depending on the content of Mn and/or an excess of alkali metals (K and Na), for example.

By increasing the content of Mn, the molar ratio of divalent Mn (Mn²⁺/(Mn³⁺ + Mn⁴⁺)) can be lowered. Meanwhile, by increasing the excess of the alkali metals in the A site, Mn²⁺/(Mn³⁺ + Mn⁴⁺) can be raised. In other words, by adjusting Mn²⁺/(Mn³⁺ + Mn⁴⁺) to a predetermined value, a piezoelectric element 300 having excellent insulating properties can be obtained with reduced leakage current. Moreover, by adjusting each of the excess of the alkali metals and a molar ratio (K/Na) of potassium to sodium, a further reduction in leakage current and an increase in displacement can be expected. Further, by setting the content of Mn to 0.3 mol% or more and 2 mol% or less, preferably 0.5 mol% or more and 1 mol% or less during the adjustment of (Mn²⁺/(Mn³⁺ + Mn⁴⁺), a piezoelectric layer 70 having excellent crystal orientation can be obtained.

The ratio of divalent Mn is believed to vary depending on other factors, such as firing conditions during the production.

A piezoelectric material that can be employed in the embodiment is not limited to the composition represented by formula (2). For example, other elements (additives) may be contained in the A site and/or the B site. Examples of additives include lithium (Li), barium (Ba), calcium (Ca), strontium (Sr), zirconium (Zr), Ti, Bi, tantalum (Ta), antimony (Sb), Fe, Co, Ag, magnesium (Mg), zinc (Zn), and copper (Cu).

One or more such additives may be contained. The amount of such additives is typically 20% or less, 15% or less, or 10% or less, based on the total amount of main component elements. The use of the additives enhances various characteristics, thereby facilitating diversification of the configuration and/or the function. Even when a complex oxide contains such other elements, the complex oxide preferably has an ABO₃ perovskite structure.

The alkali metals in the A site may be added in excess. The complex oxides of formula (2) can also be represented by formula (3). In formula (3), a represents a molar amount of K and Na. When a is greater than 1, the complex oxide has a composition in which the alkali metals in the A site are added in excess. When a is 1.1, for example, the alkali metals are contained with an excess of 10% for a total of 110%, provided that Nb is 100%. In the embodiment, the excess is preferably 4% or more and 8% or less in view of crystal orientation and insulating properties. Meanwhile, an excess of greater than 10% in particular is not preferred since diffusion of the alkali metals to the side of the first electrode 60 becomes noticeable. In formula (3), x and y satisfy similar respective ranges to those of x and y in formula (2).

(Kₐₓ,Naₐ₍₁₋ₓ₎)(Nb_{(1-y)},Mn_{y})O₃ (3)

Regarding the alkali metals in the A site, K may be added in excess relative to Na. In the embodiment, a molar ratio of K to Na (K/Na) is preferably 1.1 or less in view of crystal orientation and insulating properties.

Examples of piezoelectric materials include a material having a composition with a partially deficient element, a material having a composition with an element in partial excess, and a material having a composition with an element partially replaced with another element. Provided the basic characteristics of the piezoelectric layer 70 are unchanged, the piezoelectric materials according to the embodiment also include a material with a non-stoichiometric composition due to a deficiency and/or excess, as well as a material whose element is partially replaced with another element.

In the specification, "a complex oxide having a perovskite structure containing K, Na, Nb, and Mn" is not limited to an ABO₃ perovskite complex oxide containing K, Na, Nb, and Mn. In other words, also included is a piezoelectric material represented as a mixed crystal of an ABO₃ perovskite complex oxide containing K, Na, Nb, and Mn (a Mn-containing KNN-based complex oxide represented by formula (2) or (3)) and another complex oxide having a perovskite structure.

The other complex oxide, although not limited within the scope of the invention, is preferably a Pb-free piezoelectric material, further preferably a Pb- and Bi-free piezoelectric material. Such materials enable a piezoelectric element 300 having excellent biocompatibility and a low environmental load to be achieved.

In the embodiment, the piezoelectric layer 70 composed of the above-mentioned complex oxide is preferentially oriented along the (100)-plane, because the seed layer 65 is provided to control the orientation of the piezoelectric layer 70. The piezoelectric layer 70 may be preferentially oriented, for example, along the (110)-plane or the (111)-plane depending on a predetermined seed layer (orientation control layer) provided as needed. Various characteristics of the piezoelectric layer 70 with a preferential orientation along the (100)-plane can be enhanced more readily than those of a piezoelectric layer with a random orientation or preferential orientation along other crystal planes. In the specification, preferential orientation indicates that 50% or more, preferably 80% or more of the crystal is preferentially oriented along a predetermined crystal plane. For example, "preferential orientation along the (100)-plane" includes a case in which all the crystal of the piezoelectric layer 70 is oriented along the (100)-plane, and a case in which more than half of the crystal (60% or more, preferably 75% or more, more preferably 80% or more) is oriented along the (100)-plane.

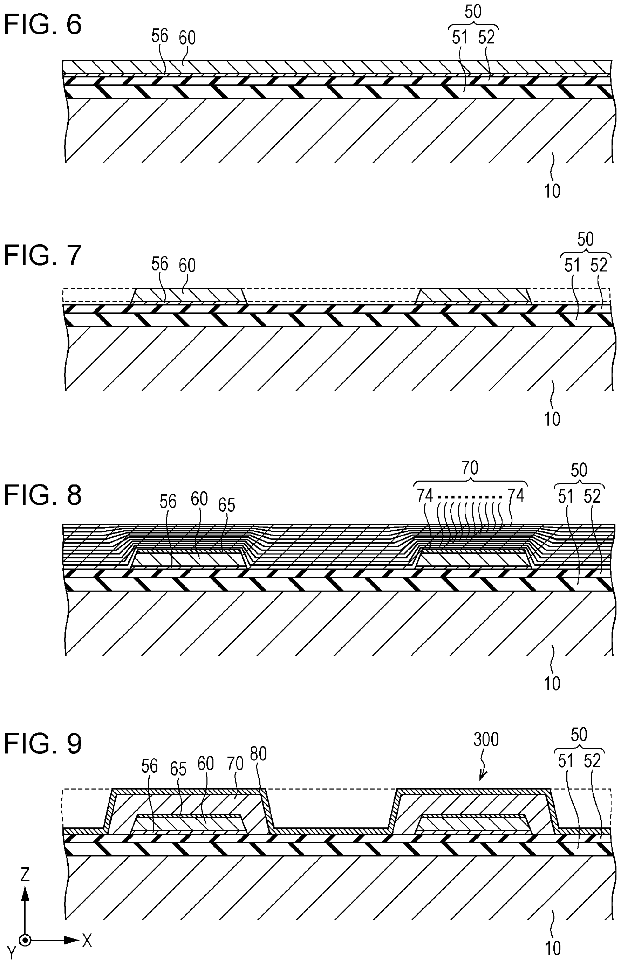

Following, an example method of manufacturing the piezoelectric element 300, and a method of manufacturing an ink jet recording head (recording head 1) will be described with reference to Figs. 6 to 12. Figs. 6 to 12 are sectional views that illustrate example of manufacturing an ink jet recording head.

First, as illustrated in Fig. 6, a Si substrate is prepared as the substrate 10. Next, the elastic film 51 composed of SiO₂ is formed on the surface of the substrate 10 by thermal oxidation. Further, a zirconium film is formed on the elastic film 51 by sputtering or vapor deposition, for example, and then thermally oxidized to yield the insulator film 52 composed of ZrO₂. As described above, the diaphragm 50 including the elastic film 51 and the insulator film 52 is formed on the substrate 10. Subsequently, the bonding layer 56 composed of TiOₓ is formed on the insulator film 52. The bonding layer 56 can be formed by sputtering or thermal oxidation of a Ti film, for example. The bonding layer 56 can be omitted. The first electrode 60 is then formed on the bonding layer 56. The first electrode 60 can be formed by vapor-phase film formation, such as sputtering, vacuum vapor deposition (PVD), or laser ablation; or by liquid-phase film formation, such as spin coating.

Subsequently, as illustrated in Fig. 7, a resist (not shown) of a predetermined shape is formed as a mask on the first electrode 60, and the bonding layer 56 and the first electrode 60 are simultaneously patterned. Such patterning of the bonding layer 56 and the first electrode 60 can be performed by, for example, dry etching, such as reactive ion etching (RIE) or ion milling; or wet etching using an etchant. The shapes of the bonding layer 56 and the first electrode 60 in patterning are not particularly limited.

As illustrated in Fig. 8, after providing the seed layer 65 on the first electrode 60, a plurality of piezoelectric films 74 are formed to overlap the bonding layer 56, the first electrode 60, and the diaphragm 50. The seed layer 65 can be omitted. The piezoelectric layer 70 is formed of the plurality of piezoelectric films 74. The piezoelectric layer 70 can be formed by, for example, a chemical solution method (wet method), such as metal-organic decomposition (MOD) in which a metal oxide is obtained by applying and drying a metal complex solution (precursor solution) and firing at a high temperature, or sol-gel processing. The piezoelectric layer 70 can also be formed by, for example, laser ablation, sputtering, pulsed laser deposition (PLD), chemical vapor deposition (CVD), or aerosol deposition.

Although the details will be described hereinafter, the piezoelectric layer 70 formed by a wet method (liquid-phase method) includes a plurality of the piezoelectric films 74 formed through a series of processes including: forming a precursor film by applying a precursor solution (coating process); drying the precursor film (drying process); degreasing the dried precursor film by heating (degreasing process); and firing the degreased precursor film (firing process). The piezoelectric layer 70 is thus formed by repeating the series of processes from the coating process to the firing process a plurality of times. In the above series of processes, the firing process may be performed after repeating the processes from the coating process to the degreasing process a plurality of times.

A layer or a film formed by a wet method has an interface. Coating or firing marks remain in a layer or a film formed by a wet method. Such marks are "interfaces" confirmable through observing the cross-section and analyzing an elemental concentration distribution within the layer (or within the film). Strictly speaking, "interface" indicates a boundary between layers or films. Herein, however, "interface" indicates the vicinity of the boundary between layers or films. When a cross-section of a layer or a film formed by a wet method is observed, for example, by using an electron microscope, such an interface is confirmed, near the boundary with an adjacent layer or film, as a portion with a darker color or a lighter color compared with the other portions. When an elemental concentration distribution is analyzed, such an interface is confirmed, near the boundary with an adjacent layer or film, as a portion with a higher elemental concentration or a lower elemental concentration compared with the other portions. The piezoelectric layer 70 is formed by repeating the series of processes from the coating process to the firing process a plurality of times; or repeating the processes from the coating process to the degreasing process a plurality of times, followed by the firing process (piezoelectric layer 70 is formed of a plurality of piezoelectric films 74). Accordingly, the piezoelectric layer 70 has a plurality of interfaces corresponding to respective piezoelectric films 74.

An example of a specific procedure of forming the piezoelectric layer 70 by a wet method is as follows. First, each precursor solution for forming the piezoelectric layer 70, such as a metal complex-containing MOD solution or sol, is prepared (preparation process). The precursor solution for the piezoelectric layer 70 is applied on the patterned first electrode 60 by spin coating, for example, to form a precursor film (coating process). Subsequently, the precursor film is heated to a predetermined temperature, such as about 130°C to about 250°C and dried for a certain period of time (drying process), and degreased by further heating the dried precursor film to a predetermined temperature, such as about 300°C to about 450°C and retained for a certain period of time (degreasing process). The degreased precursor film is then heated to a higher temperature, such as about 500°C to about 800°C, and crystallized by being retained at a temperature in the range for a certain period of time, thereby forming the piezoelectric film 74 (firing process). By repeating the coating process, the drying process, the degreasing process, and the firing process a plurality of times, the piezoelectric layer 70 including a plurality of the piezoelectric films 74 is formed.

In the above-mentioned precursor solution, a metal complex that can form the above-described perovskite complex oxide by firing is dissolved or dispersed in an organic solvent. This means that the precursor solution for the piezoelectric layer 70 contains each element of K, Na, Nb, and Mn as a central metal of a metal complex. A metal complex containing an element excluding the above elements, i.e., a metal complex containing an additive, such as Li, Ba, Ca, Sr, Zr, Ti, Ta, Sb, Fe, Co, Ag, Mg, Zn, Cu, La, Sm, Ce, or Al may be further mixed with the precursor solution for the piezoelectric layer 70.

As the metal complexes containing the above elements, alkoxides, organic acid salts, and β-diketone complexes, for example, can be used. In the above-described precursor solutions, the metal complexes may be mixed at a mixing ratio such that each predetermined element included in the perovskite complex oxide satisfies a desired molar ratio.

Examples of K-containing metal complexes include potassium 2-ethylhexanoate and potassium acetate. Examples of Na-containing metal complexes include sodium 2-ethylhexanoate and sodium acetate. Examples of Nb-containing metal complexes include niobium 2-ethylhexanoate and pentaethoxyniobium. Examples of Mn-containing metal complexes include manganese 2-ethylhexanoate. In the above examples, two or more metal complexes may be used together.
For example, potassium 2-ethylhexanoate and potassium acetate may be used together as K-containing metal complexes.

Examples of organic solvents used for preparation of the precursor solutions include propanol, butanol, pentanol, hexanol, octanol, ethylene glycol, propylene glycol, octane, decane, cyclohexane, xylene, toluene, tetrahydrofuran, acetic acid, 2-ethylhexanoic acid, 2-n-butoxyethanol, n-octane, and a mixed solvent thereof.

The precursor solution may contain an additive for stabilizing the dispersion of each metal complex. Examples of the additives include 2-ethylhexanoic acid and diethanolamine.

Heating apparatuses used in the drying process, the degreasing process, and the firing process include, for example, a rapid thermal annealing (RTA) apparatus that performs heating by irradiation with an infrared lamp, and a hot plate.

In the embodiment, the piezoelectric material contains the alkali metals (K and Na). The alkali metals readily diffuse into the first electrode 60 and the bonding layer 56 in the firing process. If the majority of the alkali metals pass through the first electrode 60 and the bonding layer 56 and reach the substrate 10, they would react with the substrate 10. In the embodiment, however, the insulator film 52 functions as a barrier against alkali metals. Accordingly, the alkali metals that reach the substrate 10 can be reduced.

As illustrated in Fig. 9, the piezoelectric layer 70 including a plurality of the piezoelectric films 74 is then patterned. Such patterning can be performed by dry etching, such as reactive ion etching or ion milling; or wet etching using an etchant. The shape of the piezoelectric layer 70 in patterning is not particularly limited. Subsequently, the second electrode 80 is formed on the patterned piezoelectric layer 70. The second electrode 80 can be formed by a method similar to the method by which the first electrode 60 is formed.

Before or after forming the second electrode 80 on the piezoelectric layer 70, a reheating process (post-annealing) may be performed as needed in a temperature range of about 600°C to about 800°C. Through the post-annealing, a good interface can be formed between the bonding layer 56 and the first electrode 60, between the first electrode 60 and the piezoelectric layer 70, and between the piezoelectric layer 70 and the second electrode 80. At the same time, the crystallinity of the piezoelectric layer 70 can be improved.

The above processes enable the piezoelectric element 300 including the first electrode 60, the piezoelectric layer 70, and the second electrode 80 to be produced.

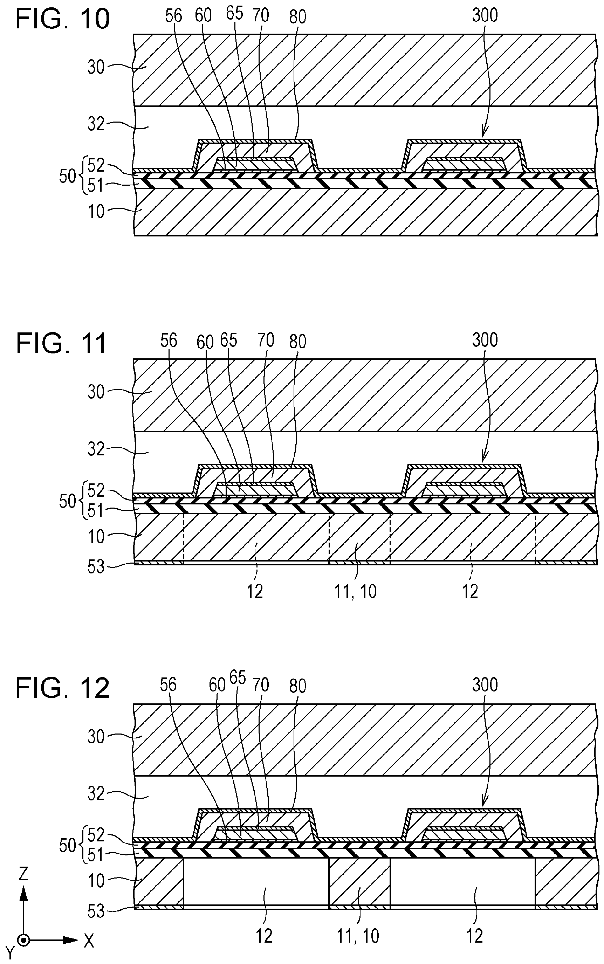

As illustrated in Fig. 10, the protective substrate 30 as a protective substrate wafer is bonded to the surface of the substrate 10 on the side of the piezoelectric element 300 by using the adhesive 35 (see Fig. 4). Subsequently, the protective substrate 30 is thinned by grinding the surface. Further, the manifold portion 32 and the through hole 33 are formed in the protective substrate 30.

As illustrated in Fig. 11, a mask film 53 is then formed on the surface of the substrate 10 on the side opposite to the piezoelectric element 300, followed by patterning into a predetermined shape. As illustrated in Fig. 12, through the mask film 53, anisotropic etching (wet etching) using an alkali solution, such as KOH, is performed on the substrate 10, thereby partitioning the substrate 10 with a plurality of partition walls 11 to form pressure chambers 12. Further, in addition to the pressure chambers 12 corresponding to individual piezoelectric elements 300, the ink supply paths 13, the connection paths 14, and the connection portion 15 are formed.

Subsequently, unnecessary portions in the outer peripheral edges of the substrate 10 and the protective substrate 30 are cut and removed by dicing, for example. Further, the nozzle plate 20 is joined to the surface of the substrate 10 on the side opposite to the piezoelectric element 300. Also, the compliant substrate 40 is joined to the protective substrate 30. The processes so far enable a chip aggregate of the recording heads 1 to be produced. The recording heads 1 are obtained by dividing the aggregate into individual chips.

### Examples

Following, the present invention will be further specifically described with reference to the following Examples. Samples 1, 5, 6 represent embodiments of the present invention, whereas samples 2-4, 7, 8 lie outside the scope of the claims.

### Preparation of Sample 1

First, a 6-inch (100)-plane silicon single crystal substrate (Si substrate) (substrate 10) was thermally oxidized to form a SiO₂ film (elastic film 51) on a surface of the Si substrate. On the SiO₂ film, a zirconium film was formed by sputtering and then thermally oxidized to form a ZrO₂ film (insulator film 52). Subsequently, a Ti film was formed on the ZrO₂ film by RF magnetron sputtering and then thermally oxidized to form a TiOₓ film (bonding layer 56). A Pt film (first electrode 60) was then formed on the TiOₓ film by RF magnetron sputtering.

Subsequently, the piezoelectric layer 70 was formed on the Pt film through the following procedure. First, a precursor solution was prepared by mixing respective n-octane solutions of potassium 2-ethylhexanoate, sodium 2-ethylhexanoate, niobium 2-ethylhexanoate, and manganese 2-ethylhexanoate.

The prepared precursor solution was applied to the Si substrate, where the Pt film was formed, by spin coating (coating process). The Si substrate was then placed on a hot plate and dried at 180°C (drying process). Subsequently, the Si substrate on the hot plate was degreased at 380°C (degreasing process). Firing at 600°C for 3 minutes was then performed in a rapid thermal annealing (RTA) apparatus (firing process) to form a single Mn-containing KNN film (piezoelectric film 74). Then, by repeating processes from the coating process to the firing process six times, seven Mn-containing KNN films were formed in total. The layered structure of the Mn-containing KNN films was then subjected to a heat treatment in an electric furnace at 700°C to form a perovskite complex oxide layer (piezoelectric layer 70) composed of potassium sodium manganate niobate having the composition of formula (4):

(K_{0.416}Na_{0.624})(Nb_{0.995}Mn_{0.005})O₃ (4)

Further, a Pt film (second electrode 80) was formed on the perovskite complex oxide layer by sputtering to yield Sample 1 (piezoelectric element 300). The compositional ratio of the Mn-containing KNN film is not substantially deviated from the compositional ratio of each metal adjusted in the precursor solution.

### Preparation of Sample 2

Sample 2 was obtained in a similar manner to Sample 1 except for forming a perovskite complex oxide layer having the composition of formula (5):

(K_{0.4}Na_{0.6})(Nb_{0.995}Mn_{0.005})O₃ (5)

XPS measurement

Sample 1 and Sample 2 were evaluated by X-ray photoelectron spectroscopy (XPS) using an "ESCALAB 250" (Thermo Fisher Scientific Inc.) under conditions of irradiation by an electron gun for charge compensation with an X-ray source (Al Kα radiation, spot size of 500 µm²).

A survey spectrum was measured at a step interval of 1 eV, a pass energy of 200 eV, and an accumulation time of 100 µs. To suppress changes in the chemical state due to X-ray damage, measurement data was obtained by averaging measurements at five or more points for each sample. The energy axis of the XPS apparatus was calibrated using Au, Ag, and Cu, and the energy axis of each measured sample was calibrated by setting C 1s, C-C, and C-H peaks to 284.8 eV. Curve fitting of Mn2p3 was performed using the Voigt function. Regarding the position of the peak energy, American Mineralogist (pages 305 to 315, volume 83) was referenced.

The surface composition and the valence of Mn were calculated based on the XPS measurement results of Samples 1 and 2, and the results are shown in Table 1. The measured results of distortion (nm) and leakage current (A/cm²) of Samples 1 and 2 are also shown in Table 1.

**Table 1**

| | K/Na | Displacement (nm) | Leakage Current (A/cm²) |
|---|---|---|---|
| Sample 1 | 1.1 | 130 | 1.30E-06 |
| Sample 2 | 3.1 | 80 | 4.70E-02 |

As shown in Table 1, Sample 1 with a K to Na molar ratio (K/Na) of 1.1 was observed to exhibit large distortion and excellent piezoelectric characteristics, as well as reduced leakage current, and thus excellent insulating properties. In contrast, Sample 2 with a K/Na of 3.1, which is notably larger than that of Sample 1, was observed to exhibit poorer piezoelectric characteristics and insulating properties compared with Sample 1.

### XRD measurement

Sample 1 was measured for X-ray diffraction (XRD) using a "D8 Discover" (Bruker AXS GmbH) with an X-ray source of Cu Kα and a two-dimensional detector (GADDS).

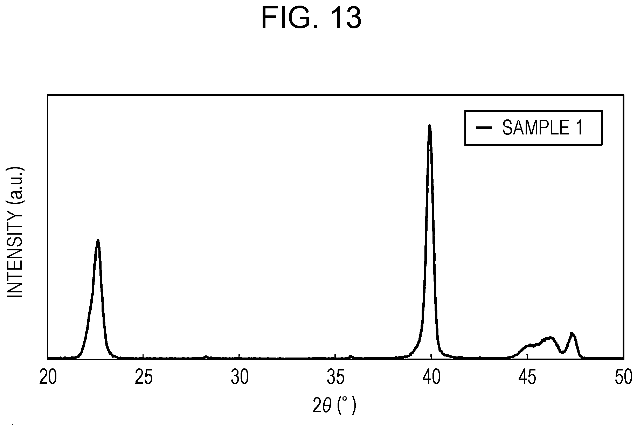

Fig. 13 is a graph indicating the XRD measurement result of Sample 1. As indicated, an intense peak originating from perovskite emerges near 2θ = 22.5°, indicating that the perovskite complex oxide that forms the piezoelectric layer 70 is oriented along the (100)-plane. From the above XPS measurement result, Sample 1 containing Mn is found to have a divalent Mn ratio (Mn²⁺/(Mn³⁺+ Mn⁴⁺)) in the range of 1 or more and 10 or less. Consequently, Sample 1 is found to be readily oriented along the (100)-plane. The intense peak emerging near 2θ = 40 originated from Pt that forms the electrodes.

### Preparation of Samples 3 to 8

Samples 3 to 8 were each obtained in a similar manner to Sample 1 except for forming a perovskite complex oxide layer having the composition shown in Table 2. In a similar manner to Sample 1, Samples 3 to 8 were measured by X-ray photoelectron spectroscopy (XPS), and the results of the calculated surface composition and valence of Mn are shown in Table 2. Table 2 also shows measured results of leakage current (A/cm²) for Samples 3 to 8.

**Table 2**

| | Alkali Excess | K/Na | Mn²⁺/(Mn³⁺ + Mn⁴⁺) | Leakage Current (A/cm²) |
|---|---|---|---|---|
| Sample 3 | 0% | 3.1 | - | 3.50E-01 |
| Sample 4 | 2% | 2.4 | 0.34 | 2.70E-01 |
| Sample 5 | 4% | 1.1 | 1.92 | 1.20E-06 |
| Sample 6 | 6% | 0.8 | 2.29 | 2.10E-06 |
| Sample 7 | 8% | 1.1 | 7.19 | 1.10E-04 |
| Sample 8 | 10% | 0.9 | 11.8 | 1.20E-04 |

As shown in Table 2, Samples 5 to 7 with a K to Na molar ratio (K/Na) of 1.1 or less and a divalent Mn ratio (Mn²⁺/(Mn³⁺+ Mn⁴⁺)) of 1 or more and 10 or less were observed to have reduced leakage current and excellent insulating properties. Meanwhile, Samples 3, 4, and 8 each have a K/Na and a Mn²⁺/(Mn³⁺+ Mn⁴⁺) outside the above ranges. Particularly, Samples 3 and 4 were observed to have large leakage current and poorer insulating properties compared with Sample 1.

### Other Embodiments

In Embodiment 1, a liquid ejecting head, which is mounted on a liquid ejecting apparatus, is described as an exemplary piezoelectric element device. The scope of application of the invention, however, is not limited to this. Although an ink jet recording head is described as an example of a liquid ejecting head, the invention is certainly applicable to a liquid ejecting head that ejects a liquid other than ink. Examples of liquid ejecting heads that eject liquids other than ink include: a colorant ejecting head employed in the manufacture of a color filter for a liquid crystal display, for example; an electrode material ejecting head employed in electrode formation for an organic EL display and a field emission display (FED), for example; and an organic biomaterial ejecting head employed in the manufacture of a biochip.

The piezoelectric element and the piezoelectric element device of the invention have high piezoelectric characteristics and are thus suitable for a piezoelectric actuator. Specific examples of the piezoelectric actuators include an ultrasonic motor, a vibration-type dust removal device, a piezoelectric transducer, a piezoelectric speaker, a piezoelectric pump, a temperature-electricity converter, and a pressure-electricity converter.

The piezoelectric element and the piezoelectric element device of the invention have high piezoelectric performance and are thus suitably employed as a piezoelectric sensor element. Specific examples of the sensor elements include an ultrasonic detector (ultrasonic sensor), an angular velocity sensor, an acceleration sensor (gyro sensor), a vibration sensor, a tilt sensor, a pressure sensor, a collision sensor, a motion sensor, an infrared sensor, a terahertz sensor, a heat detection sensor (thermal sensor), a pyroelectric sensor, and a piezoelectric sensor. Other applications include filters, such as a shielding filter of harmful rays, such as infrared rays; an optical filter utilizing photonic crystal effects by quantum dot formation; and an optical filter utilizing optical interference of a thin film.

Regarding an ultrasonic sensor-mounted ultrasonic measuring apparatus, an ultrasonic measuring apparatus can also be formed by including the piezoelectric element of the invention and a control unit for measuring a detection target by using signals based on at least one of ultrasound transmitted from the piezoelectric element of the invention or ultrasound received by the piezoelectric element of the invention. Such an ultrasonic measuring apparatus obtains information about the position, shape, velocity, and the like of a measurement target, based on the time after transmitting ultrasound until receiving an echo signal of the transmitted ultrasound reflected and returned by the measurement target. In such an apparatus, a piezoelectric element may be employed as an ultrasound generating element and/or an echo signal detecting element. Such an ultrasound generating element and/or an echo signal detecting element can provide an ultrasonic measuring apparatus with excellent displacement characteristics.

The piezoelectric element and the piezoelectric element device of the invention have high ferroelectricity, and are thus suitably employed as ferroelectric elements. Specific examples of the ferroelectric elements include a ferroelectric memory (FeRAM), a ferroelectric transistor (FeFET), a ferroelectric arithmetic circuit (FeLogic), and a ferroelectric capacitor.

The piezoelectric element and the piezoelectric element device of the invention can control a domain by using voltage and are thus suitably employed as voltage-controlled optical elements. Specific examples of the optical elements include a wavelength converter, an optical waveguide, an optical path modulator, a refractive index control element, and an electronic shutter mechanism.

The piezoelectric element and the piezoelectric element device of the invention exhibit good pyroelectric characteristics and are thus suitably employed as pyroelectric elements. Further applications include, for example, a robot utilizing the various above-mentioned motors as driving sources.

## Claims

1. A piezoelectric element (300) comprising:
a first electrode (60) formed on a substrate (50);
a piezoelectric layer (70) formed on the first electrode and composed of a complex oxide having a perovskite structure containing potassium (K), sodium (Na), niobium (Nb), and manganese (Mn), wherein the perovskite structure is represented by a general formula of ABO₃ and wherein an A-site element is present in excess relative to a B-site element, wherein the amount of the excess is 4 to 6%; and
a second electrode (80) formed on the piezoelectric layer, wherein
the manganese includes divalent manganese (Mn²⁺), trivalent manganese(Mn³⁺), and tetravalent manganese (Mn⁴⁺);
a molar ratio of the divalent manganese to a sum of the trivalent manganese and the tetravalent manganese (Mn²⁺/(Mn³⁺ + Mn⁴⁺)) is 1 or more and 10 or less;
**characterized in that** a molar ratio of the potassium to the sodium (K/Na) at the surface of the piezoelectric layer (70), measured by X-ray photoelectron spectroscopy (XPS), is 0.8 to 1.1.

2. The piezoelectric element according to Claim 1, wherein the complex oxide having a perovskite structure is represented by formula (1):
(Kₓ,Na₍₁₋ₓ₎)(Nb_{(1-y)},Mn_{y})O₃ (1)
where x satisfies 0.1 ≤ x ≤ 0.9; and y satisfies 0.003 ≤ y ≤ 0.02.

3. A piezoelectric element device (1) comprising the piezoelectric element according to claim 1 or claim 2.

## Patentansprüche

1. Piezoelektrisches Element (300), umfassend:
eine erste Elektrode (60), die auf einem Substrat (50) gebildet ist;
eine piezoelektrische Schicht (70), die auf der ersten Elektrode gebildet ist und aus einem komplexen Oxid mit einer Perowskitstruktur besteht, die Kalium (K), Natrium (Na), Niob (Nb) und Mangan (Mn) beinhaltet, wobei die Perowskitstruktur durch eine allgemeine Formel ABO₃ dargestellt ist und wobei ein A-Stellenelement im Überschuss relativ zu einem B-Stellenelement vorhanden ist, wobei die Menge des Überschusses 4 bis 6 % ist; und
eine zweite Elektrode (80), die auf der piezoelektrischen Schicht gebildet ist, wobei
das Mangan zweiwertiges Mangan (Mn²⁺), dreiwertiges Mangan (Mn³⁺) und vierwertiges Mangan (Mn⁴⁺) enthält;
ein Molverhältnis des zweiwertigen Mangans zu einer Summe des dreiwertigen Mangans und des vierwertigen Mangans (Mn²⁺/ (Mn³⁺ - Mn⁴⁺)) 1 oder mehr oder 10 oder weniger ist;
**dadurch gekennzeichnet, dass** ein Molverhältnis des Kaliums zu dem Natrium (K/Na) an der Oberfläche der piezoelektrischen Schicht (70), gemessen durch Röntgenphotoelektronenspektroskopie (XPS) 0,8 bis 1,1 ist.

2. Piezoelektrisches Element nach Anspruch 1, wobei das komplexe Oxid mit einer Perowskitstruktur durch Formel (1) dargestellt ist:
(Kₓ, Na₍₁₋ₓ₎) (Nb_{(1-y)},MN_{y})O₃ (1)
wo x 0,1 ≤ x ≤ 0,9 erfüllt; und y 0,003 ≤ y ≤ 0,02 erfüllt.

3. Piezoelektrische Elementvorrichtung (1), umfassend das piezoelektrische Element nach Anspruch 1 oder Anspruch 2.

## Revendications

1. Élément piézoélectrique (300) comprenant :
une première électrode (60) formée sur un substrat (50) ;
une couche piézoélectrique (70) formée sur la première électrode et composée d'un oxyde complexe ayant une structure pérovskite contenant du potassium (K), du sodium (Na), du niobium (Nb), et du manganèse (Mn), dans lequel la structure pérovskite est représentée par une formule générale ABO₃ et dans lequel un élément de site A est présent en excès par rapport à un élément de site B, dans lequel la quantité de l'excès est de 4 à 6 % ; et
une deuxième électrode (80) formée sur la couche piézoélectrique, dans lequel
le manganèse comprend du manganèse divalent (Mn²⁺), du manganèse trivalent (Mn³⁺), et du manganèse tétravalent (Mn⁴⁺) ;
un rapport molaire entre le manganèse divalent et une somme du manganèse trivalent et du manganèse tétravalent (Mn²⁺/(Mn³⁺ + Mn⁴⁺)) est de 1 ou plus et 10 ou moins ;
**caractérisé en ce qu'**un rapport molaire entre le potassium et le sodium (K/Na) à la surface de la couche piézoélectrique (70), mesuré par spectroscopie de photoélectrons X (XPS), est de 0,8 à 1,1.

2. Élément piézoélectrique selon la revendication 1, dans lequel l'oxyde complexe ayant une structure pérovskite est représenté par la formule (1) :
(Kₓ,Na₍₁₋ₓ₎) (Nb_{(1-y)},Mn_{y})O₃ (1)
où x satisfait à 0,1 ≤ x ≤ 0,9 ; et y satisfait à 0,003 ≤ y ≤ 0,02.

3. Dispositif à élément piézoélectrique (1) comprenant l'élément piézoélectrique selon la revendication 1 ou la revendication 2.
